# EUROPEAN PATENT APPLICATION

(11) **EP 2 099 079 A1**
(43) Date of publication of application: **09.09.2009**
(21) Application number: 08154194.8
(22) Date of filing: 08.04.2008
(51) Int. Cl.: H01L 35/32, H01L 31/058

(54) **Hybrid energy scavenger comprising thermopile unit and photovoltaic cells**

(30) Priority: 05.03.2008 US 34047 P
(71) Applicant: Stichting IMEC Nederland, 5656 AE Eindhoven (NL)
(72) Inventor: Leonov, Vladimir, 3010, Leuven (BE)
(74) Representative: Bird, William Edward

(57) **Abstract**

A hybrid energy scavenger (60) for connection between a heat source and a heat sink comprises a hot plate (37) for connection to the heat source and a heat dissipating structure (49) for connection to the heat sink. A thermopile unit (50) is mounted between the hot plate (37) and the heat dissipating structure (49). The heat dissipating structure (49) comprises at least one photovoltaic cell (56). The photovoltaic cell can generate an electrical output which can be used in addition to, or as an alternative to, an electrical output from the thermopile unit. The photovoltaic cell (56) can be mounted on, and thermally connected to, an element of the heat dissipating structure (49). The photovoltaic cell (56) can be used as a structural element of the heat dissipating structure (49).

## Description

### Technical field of the invention

The present invention relates to thermoelectric generators (TEGs) or energy scavengers.

### Background of the invention

A thermoelectric generator (TEG) utilises a temperature difference occurring between a hot (warm) object, i.e. a heat source, and its colder surrounding, i.e. a heat sink, or vice versa, and is used to transform a consequent heat flow into a useful electrical power. The necessary heat can for example be produced by radioactive materials, as e.g. in space applications, or by sources available in the ambient, like e.g. standard cooling/heating systems, pipelines including pipelines with warm waste water, surfaces of engines, parts of machines and buildings or by endotherms such as warm-blooded animals or human beings. Natural temperature gradients could be used to provide the heat for the TEGs as well, such as geothermal temperature gradients, temperature gradients on ambient objects when naturally cooling/heating at night/day, temperature differences between a fluid in a pipeline and its surrounding, heated machinery, engines, transport and ambient air, between window glass and air indoor or outdoor, etc.

TEGs can be characterised by an electrical and a thermal resistance and by both voltage and power generated per unit temperature difference between the hot and cold sides of the TEG. The relative importance of these factors depends on the specific application. In general, the electrical resistance is preferably low and, obviously, voltage or power output should be maximised (in particular in applications with small temperature difference, i.e. a few degrees C or a few tens degrees C). If a constant temperature difference is imposed at the boundaries of a TEG, e.g. by means of hot and cold plates at fixed temperatures relative to each other, the value of its thermal resistance is not crucial, because the output voltage and the output power are proportional to the temperature difference, which is fixed. Contrary thereto, if the boundary condition is a constant heat flow or a limited heat flow through the device, then the thermal resistance, on one hand, has to be large enough to generate a reasonable temperature drop over the device, but on the other hand, has to be small enough to avoid a dramatic decrease in the heat flow through the TEG, for example by more than a factor of 2. The term "constant heat flow" means that in the considered range of TEG thermal resistances the heat flow through the device is constant (limited by the ambient). However, this does not mean that the heat flow stays at the same value over time in a practical application. The term "limited heat flow" means that when decreasing the thermal resistance of the TEG, the heat flow through the device increases till a certain value, at which the conditions of constant heat flow are reached. In the case of "limited heat flow" the heat flow through the device is not limited by the ambient objects/fluids only, but also for example by the thermal resistance of the TEG.

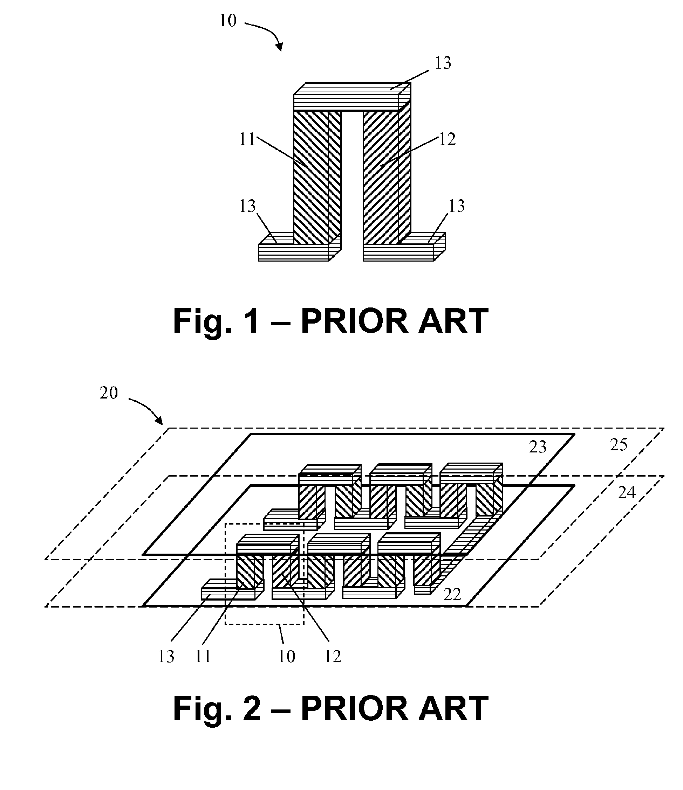

The basic element of a TEG is a thermocouple 10 (Fig. 1). An example of a thermocouple 10 for use with the present invention comprises a first leg 11 and a second leg 12 formed of two different thermoelectric materials, for example of the same but oppositely doped semiconductor material and exhibiting low thermal conductance and low electrical resistance. For example, the legs 11, 12 could be formed from BiTe. If the first leg 11 is formed of n-type BiTe, then the second leg 12 may be formed of p-type BiTe, and vice versa. The legs 11, 12 are connected by an electrically conductive interconnect, e.g. a metal layer interconnect 13, which forms a low-resistance ohmic contact to the semiconductor legs 11, 12, thus forming a junction between the semiconductor legs 11,12.

In Fig. 2, a TEG 20 comprising a thermopile 21 comprising a plurality, preferably a large number, of thermocouples 10, is shown wherein the junctions between legs 11, 12 are located in two planes: a hot junction plane 24 and a cold junction plane 25. The thermopile 21 is sandwiched in between a hot plate 22 and a cold plate 23. The hot plate 22 and the cold plate 23 are made of materials having a large thermal conductivity, so that the thermal conductance of the plates 22, 23 is much larger (at least a factor of 10) than the total thermal conductance of the thermopile 21. In case of a constant or limited heat flow through the TEG 20, the output voltage and power depend on the number of thermocouples 10 comprised in it.

There is an increasing interest in low-cost TEGs, which could replace batteries in consumer electronic products operating at low power, and in wearable and thus miniaturised TEGs. For example, TEGs mounted in a wristwatch have been used to generate electricity from wasted human heat, thus providing a power source for the watch itself. MEMS technology has been used to fabricate miniaturised TEGs and thin film technology has been used to fabricate miniaturised TEGs on a thin polymer tape.

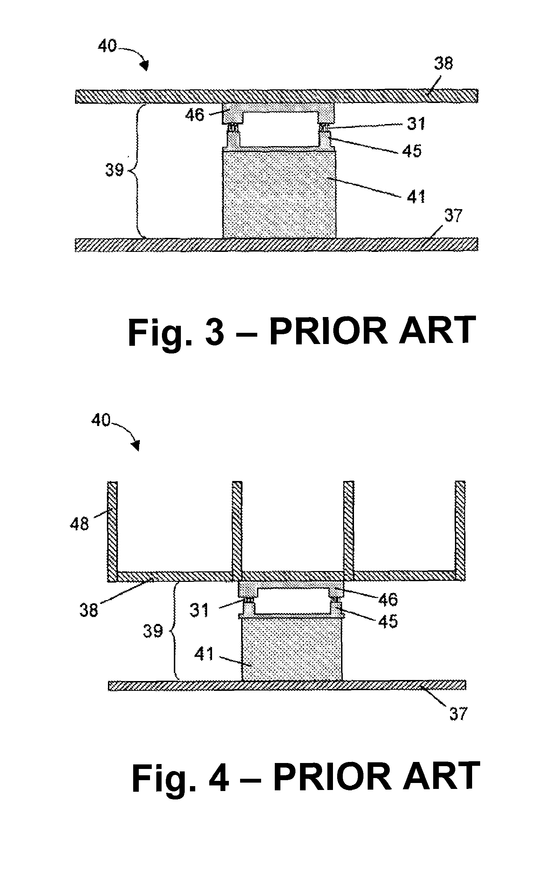

In EP 1 612 870 and US 2006/0000502, a micromachined TEG is proposed specially suited for application on heat sources a having large thermal resistance, e.g. on living beings. It is shown that a good TEG for such applications preferably comprises a hot plate and a radiator, both having a larger size than the thermopile. A TEG 40 according to EP 1 612 870 and US 2006/0000502 is depicted in Figs. 3 and 4, with a micromachined thermopile 31 between a hot die 45 featured with a pillar/rim structure and a cold die 46, provided with a spacer 41 to increase the distance 39 in between the two plates 37, 38. The cold plate 38 can also be folded or shaped as a radiator 48 of more complex shapes, e.g. as shown in Fig. 4 for a multi-fin or a multi-pin radiator case. The radiator 48 in this case includes a plate 38 as one of its components.

In unpublished European Patent Application EP 07 075 738, freestanding and membrane-type film-based thermopiles are proposed. A film-based freestanding or membrane-based thermopile with thermal shunts according to EP 07 075 738 is illustrated in Fig. 7. The thermopile chip 30 comprises a large number of thermocouples 10 manufactured on a membrane 34. Each thermocouple 10 comprises two thermocouple lines, each thermocouple line comprising a thermoelectric part 31 or a thermocouple leg 31 and an interconnect 32. The thermoelectric parts 31 or thermocouple legs 31 of one thermocouple 10 are made of two different thermoelectric materials, for example a p-type semiconductor material for one of the thermocouple legs and an n-type semiconductor material for the other thermocouple leg. The interconnect 32 is made of an electrically highly conductive layer. The membrane 34 may be connected to a carrier frame with sides 33, for example a silicon carrier frame. The membrane 34, e.g. a silicon nitride membrane, interconnects the hot side 35 of the thermopile chip 30 and its cold side 36. Furthermore, the membrane 34 can be removed, e.g. etched away, thereby ending with freestanding thermocouple legs 31, i.e. with a membrane-less thermopile.

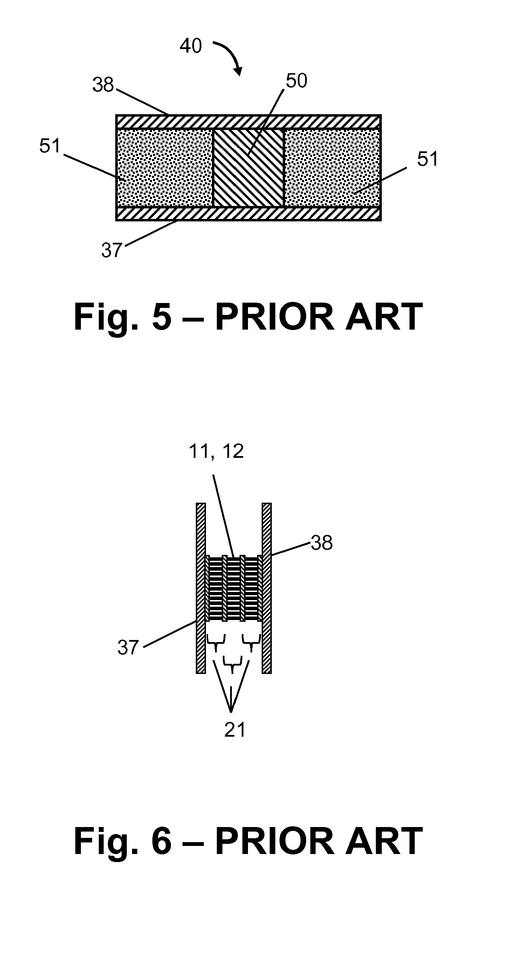

Fig. 5 shows a general scheme of a TEG 40 comprising a thermopile unit 50, the thermopile unit comprising at least one thermopile 21, which in its simplest shape is formed by a plurality of thermocouples 10 electrically connected in series, and placed in between a hot plate 37 and a cold plate 38. A thermal isolation 51 may be present at one or more sides of the thermopile unit 50, and may be formed by vacuum, air or another thermally insulating material, and may include pillars and/or encapsulating structures.

In unpublished European Patent Application EP 07 447 010, a TEG 40 thermally matched to the heat source and the heat sink is proposed wherein a good efficiency can be reached in case the TEG operates under conditions of non-constant heat flow and non-constant temperature difference between hot and cold plates. A multi-stage thermopile according to EP 04 447 010 is shown in Fig. 6, wherein three thermopile stages are shown as an example.

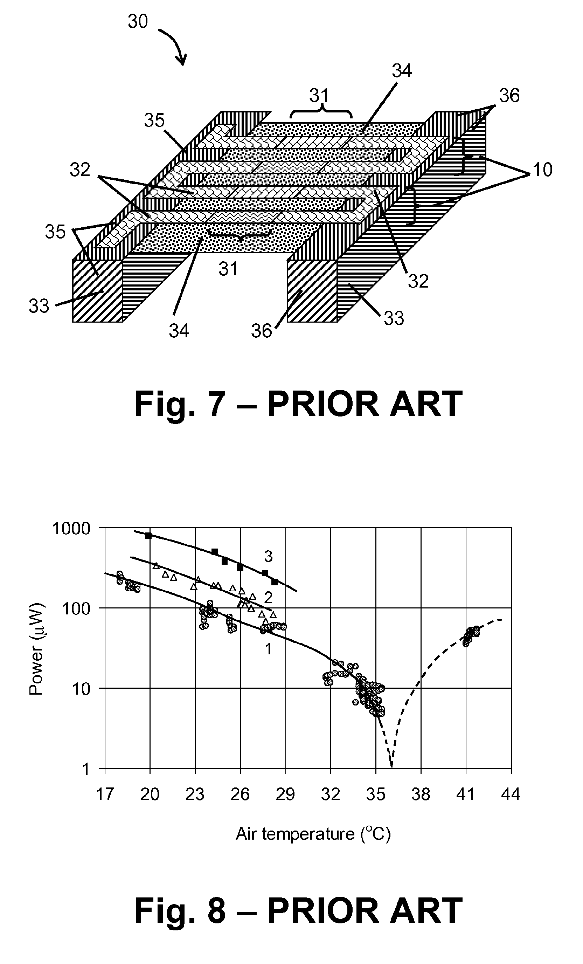

The measured output power of a device fabricated according to EP 07 447 010 and with a human body as a heat source is shown in Fig. 8 as a function of ambient temperature. The curve (1) refers to measurements on a person quietly sitting for a very long time (hours) with no intermediate activity; curve (2) is obtained when a person performs usual activity in the office in between the measurements, however, at least 5-10 minutes before the measurements, all activity is stopped, and curve (3) is measured on a person walking indoor at about 4 km/hr. From Fig. 8 it can be concluded that several hundreds of µW of power can be generated with this device. An important aspect of wearable TEGs using a human body as a heat source is the heat flow per square centimetre of the skin under the TEG. It is practically limited to about 20-30 mW/cm², because otherwise the device may start to be uncomfortable for the user. This limits the power production on human beings to about 30 µW/cm² (see e.g. V. Leonov et al., "Thermal matching of a thermoelectric energy scavenger with the ambience", Proceedings of the 5th European Conference on Thermoelectrics, Odessa, Ukraine, Sept. 2007, pp. 129-133). For a wearable device consuming low power, e.g. 100 µW, the thermopiles and TEGs, e.g. according to EP 1 612 870, EP 07 447 010, and EP 07 075 738 can produce enough power at the voltage needed in a watch-size TEG. For relatively complex wearable devices, such as for example a body-powered EEG system, a power of 1 mW to 2 mW or even higher may be required. This may be obtained by increasing the size of the TEG. However, bigger (and thus heavier) TEGs may be uncomfortable for the wearer. Therefore there is a need for increasing the power output of wearable energy scavengers, such as wearable TEGs, without increasing the size and weight.

From Fig. 8 it can also be concluded that the performance of a TEG with a human body as a heat source strongly depends on the ambient temperature. Especially in the range around body temperature (e.g. in the range between 32°C and 39°C ambient temperature) the power generated by the TEG is significantly lower than at ambient temperatures below e.g. 25°C. Therefore there is a need for a wearable energy scavenger with an output power that is less dependent on ambient temperature.

WO 00/05769 describes a differential voltage cell which includes one or more units comprising a photovoltaic device or solar cell and a thermoelectric Peltier device. The device is intended to increase the electrical power generated by photovoltaic cells. Unused heat is directed partially into an attached thermopile unit to generate additional energy. WO 00/05769 teaches cooling the thermopile unit at a side opposite to the side where the photovoltaic cell is located.

### Summary of the invention

A first aspect of the invention provides a hybrid energy scavenger for connection between a heat source and a heat sink, the hybrid energy scavenger comprising: a hot plate for connection to the heat source; a heat dissipating structure for connection to the heat sink; a thermopile unit mounted between the hot plate and the heat dissipating structure; and **characterised in that** the heat dissipating structure comprises at least one photovoltaic cell.

The photovoltaic cell can generate an electrical output which can be used in addition to, or as an alternative to, an electrical output from the thermopile unit. In this way, the energy scavenger is better able to cope with variations in ambient temperature, or temperature difference across the thermopile, and can better cope with the energy demands of a load.

The term "heat dissipating structure" is intended to encompass a wide range of physical arrangements. In a simplest form, the heat dissipating structure can comprise a single photovoltaic cell mounted to the thermopile unit. In this simplest form it is advantageous that the interface, or contact area, between the heat dissipating structure and the heat sink (i.e. the surface area of the photovoltaic cell) is greater than the area of the thermopile unit in a plane parallel to the hot plate. Advantageously, the heat dissipating structure comprises a plurality of structural elements. The structural elements have an advantage of increasing the contact area between the heat dissipating structure and the heat sink.

The photovoltaic cell can be mounted on an element of the heat dissipating structure and advantageously is thermally connected to the element of the heat dissipating structure on which it is mounted. This allows the photovoltaic cell to contribute to the heat dissipation properties of the heat dissipating structure. Advantageously, the photovoltaic cell is mounted to an outer face of the heat dissipating structure, such as a side face or an upper face of the heat dissipating structure.

The photovoltaic cell can be used as a structural element of the heat dissipating structure. This avoids the need to provide a structural element and a photovoltaic cell, which can reduce the overall size, weight and cost of the heat dissipating structure. In one embodiment, every structural element of the heat dissipating structure consists of a photovoltaic cell.

In an advantageous embodiment of the invention a thermally conductive spacer is positioned between the thermopile unit and at least one of: the hot plate and the heat dissipating structure.

Preferably the at least one photovoltaic cell has a low thermal resistance, and advantageously has a thermal conductance of substantially greater than 0.5W/cm.K.

In a hybrid energy scavenger according to embodiments of the present invention, the heat source may have a thermal resistance in the range between 10 cm²K/W and 1500 cm²K/W.

In a hybrid energy scavenger according to embodiments of the present invention, the heat sink may have a thermal resistance in the range between 10 cm²K/W and 1500 cm²K/W.

In an advantageous embodiment of the invention the heat dissipating structure comprises a cold plate which is positioned in between the thermopile unit and the at least one photovoltaic cell.

In another advantageous embodiment of the invention the heat dissipating structure comprises a radiator. The radiator can comprise a plurality of thermally conducting structural elements with at least one of: a photovoltaic cell mounted to at least one of the structural elements; a photovoltaic cell forming one of the structural elements; a photovoltaic cell mounted to an outer face of the radiator. In particular embodiments of the present invention, the radiator may be positioned between the thermopile unit and the at least one photovoltaic cell.

In an advantageous embodiment of the invention the hybrid energy scavenger is in the form of a wearable device.

Another aspect of the invention provides a wearable device or an autonomous device comprising a hybrid energy scavenger according to any one of the preceding claims.

A further aspect of the invention provides a method of generating electrical energy using the hybrid energy scavenger.

Energy scavengers according to embodiments of the invention may be used for generating electrical power, for example for powering a wearable electrical device (e.g. a watch, communications device or media player) or an autonomous device. Energy scavengers according to embodiments of the present invention may be used with an animal, a human being, a clothed human being or ambient air as a heat source and with ambient air, an animal, a human being or a clothed human being as a heat sink. The thermoelectric generator according to embodiments of the present invention may be used with a space object or an artificial space object as a heat source and interplanetary space, a space object or an artificial space object as a heat sink. The thermoelectric generator may be used with a distant radiating object or a plurality of distant radiating objects like space objects or ambient objects as a heat source and Earth surface as a heat sink.

These and other characteristics, features, and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Fig. 1 is a general schematic illustration of a thermocouple comprising an n-type and a p-type semiconducting leg and electrically conductive interconnects, e.g. metal layer interconnects.
Fig. 2 is a schematic illustration of a prior art TEG comprising a large number of thermocouples sandwiched in between a hot plate and a cold plate; the example illustrated only shows 6 thermocouples, but the TEG may comprise many more.
Fig. 3 is a cross-sectional view of an assembly of a micromachined thermopile chip and a micromachined heat-spreading chip with two plates and a spacer, according to EP 1 612 870.
Fig. 4 is a cross-sectional view of an assembly of a micromachined thermopile chip and a micromachined heat-spreading chip with a spacer and a radiator according to EP 1612870.
Fig. 5 shows a cross-sectional general view of a TEG comprising the assembly of a thermopile unit with hot and cold plates.
Fig. 6 shows a TEG with a multi-stage thermopile unit according to EP 07 447 010.
Fig. 7 is a view of a thermopile chip with a membrane thermopile according to EP 07 075 738.
Fig. 8 shows measurement results of the power transmitted into a matched load by a TEG according to EP 07 447 010.
Fig. 9 shows a hybrid energy scavenger according to an embodiment of the present invention, wherein the heat dissipating structure is composed of photovoltaic cells.
Fig. 10 shows a hybrid energy scavenger according to an embodiment of the present invention, wherein the heat dissipating structure is a photovoltaic cell acting as a cold plate.
Fig. 11 shows a hybrid energy scavenger according to an embodiment of the present invention, wherein the heat dissipating structure comprises photovoltaic cells and a cold plate placed in between the thermopile unit and the photovoltaic cells.
Fig. 12 shows a hybrid energy scavenger according to an embodiment of the present invention, wherein the heat dissipating structure comprises photovoltaic cells and a cold plate shaped as a pin-featured or a fin-featured radiator, in between the thermopile unit and the photovoltaic cells.
Fig. 13 shows a hybrid energy scavenger according to another embodiment of the present invention.
Fig. 14 shows a prior art hybrid energy scavenger comprising a thermopile unit and a photovoltaic cell.
Fig. 15 shows a prior art hybrid energy scavenger comprising a radiator.
Fig. 16 shows a hybrid energy scavenger according to an embodiment of the present invention.
Fig. 17 shows a hybrid energy scavenger according to an embodiment of the present invention.
Fig. 18 shows the thermal circuit used for modelling a prior art device as shown in Fig. 15.
Fig. 19 shows the thermal circuit used for modelling a prior art device as shown in Fig. 14.
Fig. 20 shows the thermal circuit used for modelling a hybrid energy scavenger according to the present invention.
Fig. 21 illustrates qualitatively the relative importance of the power generated on 24-hour average by a thermopile unit and the power generated on 24-hour average by photovoltaic cells, depending on ambient conditions.
Fig. 22 shows a hybrid energy scavenger according to an embodiment of the present invention with a comb-like hot plate featuring thermally conductive pins or fins for positioning the scavenger on the hair of a person or on the coat of animal.
Fig. 23 shows a power supply using the hybrid energy scavenger of Figure 17.

In the different figures, the same reference numbers refer to the same or analogous elements.

### Description of illustrative embodiments

In the following detailed description, numerous specific details are set forth in order to provide a thorough understanding of the invention and how it may be practiced in particular embodiments. However it will be understood that the present invention may be practiced without these specific details. In other instances, well-known methods, procedures and techniques have not been described in detail, so as not to obscure the present invention. While the present invention will be described with respect to particular embodiments and with reference to certain drawings, the reference is not limited hereto. The drawings included and described herein are schematic and are not limiting the scope of the invention. It is also noted that in the drawings, the size of some elements may be exaggerated and, therefore, not drawn to scale for illustrative purposes.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

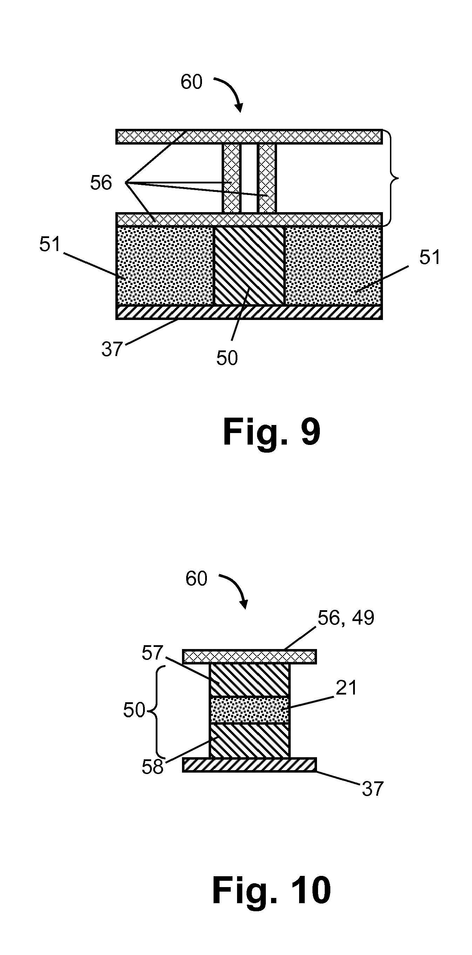

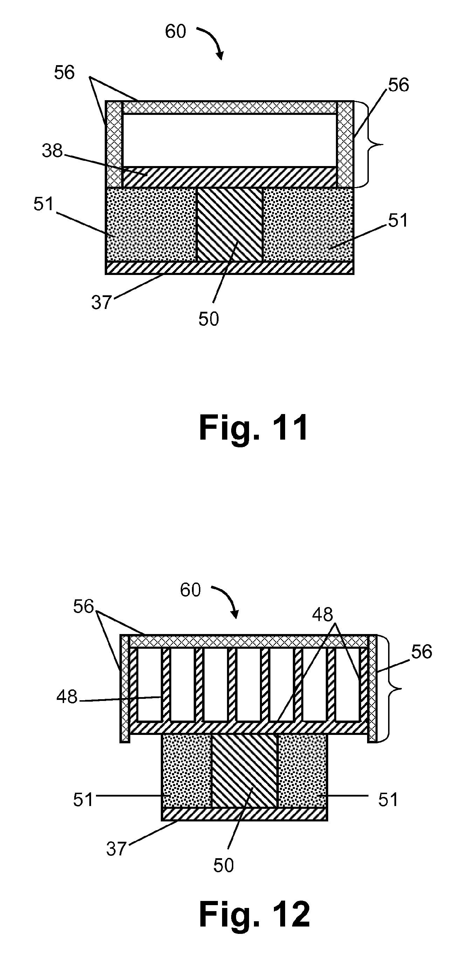

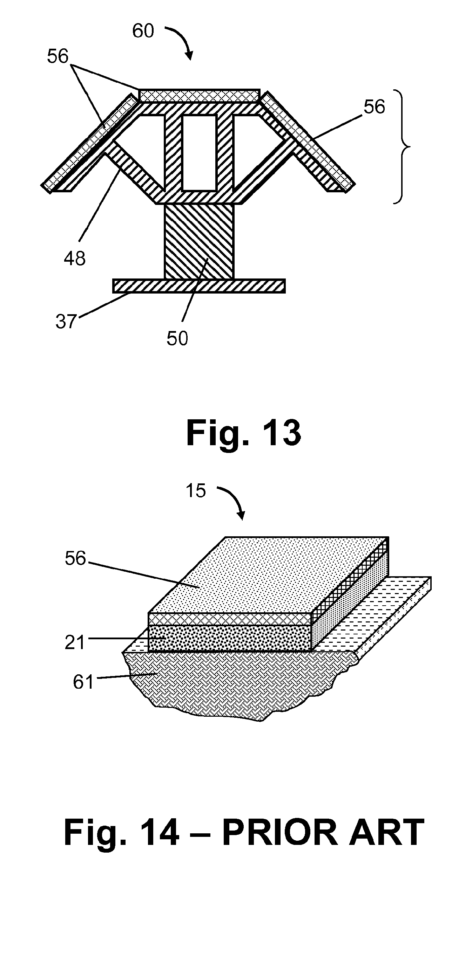

Fig. 9 illustrates a hybrid energy scavenger 60 according to an embodiment of the present invention, the hybrid energy scavenger 60 comprising a thermopile unit 50 being placed between a hot plate 37 and a thermally conductive heat dissipating structure 49. In embodiments of the present invention the heat dissipating structure 49 comprises photovoltaic cells 56. In the embodiment shown in Fig. 9, the heat dissipating structure 49 is composed of photovoltaic cells 56. In other embodiments of the present invention, in addition to the photovoltaic cells 56, the heat dissipating structure 49 may comprise for example a cold plate 38 and/or a radiator 48 or a cold plate shaped as a radiator 48, the cold plate 38 and/or the radiator 48 being placed in between the thermopile unit 50 and the photovoltaic cells 56. This is illustrated in Figs. 11 to 13. Providing a cold plate 38 or a radiator 48 in between the thermopile unit 50 and the photovoltaic cells 56 enhances the heat transfer from the thermopile unit 50 to the ambient, e.g. ambient air. At usual ambient temperatures, i.e. typically between 15°C and 25 °C, e.g. at 20°C, the thermal resistance of the human body R_{th,body} ranges from about 100 cm^{2.}K/W to about 1000 cm^{2.}K/W with the possibility to be out of the mentioned range; the thermal resistance of ambient air is in the same range. Therefore, by increasing the contact area between the heat dissipating structure 49 and the heat sink, e.g. ambient air, and/or by increasing the contact area between the hot plate 37 and the heat source, e.g. a human body, the heat flow from the heat source, e.g. the body, to the heat sink, e.g. ambient air, can be enhanced. Increasing the contact area between the heat dissipating structure 49 and the heat sink may be done by e.g. replacing the cold plate 38 (e.g. as shown in Fig. 11) with a radiator 48 (i.e. changing the shape and dimensions of the cold plate 38), as for example illustrated in Figs. 12 and 13. In embodiments of the present invention it is preferred that the area of the interface between the heat dissipating structure 49 and the heat sink, e.g. ambient air, is substantially larger, preferably at least a factor of two, still more preferred at least a factor of 3, than the area of the thermopile unit 50 in a plane parallel to the hot plate 37. Increasing the contact area between the hot plate 37 and the heat source may be done by e.g. increasing the size of the hot plate 47. However, e.g. when using the human body as a heat source, adapting the shape of the hot plate 37 without increasing its size may offer a significant improvement of the generated power. For example, the human wrist has a non-uniform temperature and the thermal resistance varies on its circumference. Therefore a hot plate of 1 × 4 cm² placed along the radial or ulnar artery according to EP 07 447 010, provides better heat flow than a hot plate of 2 × 2 cm², the better heat flow resulting in larger generated power.

In embodiments of the present invention it is preferred that the thermal resistance of the heat dissipating structure 49 is substantially lower, e.g. at least a factor of 10 lower, than the thermal resistance of the thermopile unit 50. Therefore, as the photovoltaic cells 56 are part of the heat dissipating structure 49, it is preferred that their thermal resistance is low (i.e. substantially lower, e.g. at least a factor of 10 lower, than the thermal resistance of the thermopile unit 50). For example, it is preferred to use photovoltaic cells 56 made from a material with a good thermal conductivity (e.g. silicon, having a thermal conductivity of 1,49 W/cm.K at 300 K).

In embodiments of the present invention a thermal isolation 51 may be present at one or more sides of the thermopile unit 50, as for example illustrated in Figs 9, 11 and 12.

The hybrid energy scavenger 60 may be thermally optimized and preferably follows the thermal matching condition described in European patent application no. EP 04 447 010. The performance of the hybrid energy scavenger 60 may be further increased by adding at least one thermally conductive spacer 57 or 58 or two spacers 57, 58 into the thermopile unit 50 (as e.g. described in EP 04 007 010), thus separating the thermopile 21 from the hot plate 37, and/or from the heat dissipating structure 49 comprising the photovoltaic cells 56. This is illustrated in Fig. 10.

It is an advantage of a hybrid energy scavenger 60 according to embodiments of the present invention that the heat dissipating structure 49, comprising photovoltaic cells 56, can generate electrical energy from ambient light, in addition to the energy generated by the thermopile unit 50 from a heat source (e.g. human body), without increasing the size or the weight as compared to prior art TEGs (e.g. as illustrated in Fig. 5). This means that the power output of wearable hybrid energy scavengers comprising thermopile units may be increased as compared to prior art solutions, without increasing the size and weight. It is another advantage of a hybrid energy scavenger 60 according to embodiments of the present invention that at higher ambient temperatures (e.g. higher than 25°C), when the power generated by the thermopile unit 50 (using the human body as a heat source) decreases as illustrated in Fig. 8, the energy generated by the photovoltaic cells 56 may lead to less dependency of the total output power on ambient temperature as compared to prior art solutions.

In prior art documents, such as for example WO 2000/05769, hybrid power sources are described which comprise both photovoltaic cells and a thermopile unit. These power sources were developed for increasing the electrical power generated by photovoltaic cells. It is known that only a small portion of the sun's spectrum is converted by photovoltaic cells, while unused heat is dissipated in the cells. In the hybrid power sources described in the prior art the unused heat is directed partially into an attached thermopile unit to generate additional energy.

The prior art teaches that cooling the thermopile unit at a side opposite to the side where the photovoltaic cell is located, i.e. providing a radiator with a low thermal resistance, is advantageous as this may lead to a higher electrical output. Contrary to the teachings of the prior art, instead of cooling the thermopile unit at the side opposite to the side where the photovoltaic cells are located, in embodiments of the present invention this side of the thermopile unit is connected to a heat source, more in particular a heat source with a high thermal resistance, such as for example a human body.

The main area of application of the prior art devices is the generation of electricity at a level of kilowatts and more, in outdoor applications where direct sunlight is available. Therefore, in prior art devices it is preferred to provide a lens or a reflector for concentrating sunlight on the photovoltaic cell. Concentration of sunlight leads to a higher output from the photovoltaic cell and to higher photovoltaic cell temperatures and thus to a higher temperature difference between both sides of the hybrid power source, resulting in a higher power output. Contrary thereto, the main area of application of devices according to the present invention is the generation of electricity at a level of milliwatts or less, e.g. for powering wearable and autonomous devices, both for indoor and outdoor applications. Concentration of light on the photovoltaic cells 56 would be a disadvantage in embodiments of the present invention, as concentration of light would lead to an increase of the temperature of the photovoltaic cells, which would counteract the heat dissipating function of the photovoltaic cells 56. Furthermore, as the hybrid energy scavengers of the present invention may mainly be used in indoor applications, concentration of light is not an issue, as generally only diffuse light is available indoor, which cannot be effectively concentrated.

Therefore, the design and the requirements of the hybrid energy scavenger 60 of the present invention are substantially different from prior art hybrid power sources. For example, in the present invention the photovoltaic cells 56 preferably have a low thermal resistance, as they function as a heat dissipating element being part of the heat dissipating structure 49, the heat dissipating structure 49 being for enhancing heat transfer from the thermopile unit 50 to the ambient, e.g. ambient air. In hybrid energy scavengers 60 according to embodiments of the present invention, the thermal conductivity of the substrate material used for the fabrication of the photovoltaic cells 56 is preferably high, for example higher than 0.5-1 W/cm.K. In prior art devices, the thermal resistance of the photovoltaic cells is not an issue and any type of substrate for the photovoltaic cells may be appropriate. Furthermore, in prior art devices a good thermal contact between the photovoltaic cells and the thermopile unit is preferred, for avoiding losses of thermal energy in between the photovoltaic cells and the thermopile unit. In embodiments of the present invention it is preferred to provide e.g. a radiator 48 between the thermopile unit 50 and the photovoltaic cells 56 to enhance heat transfer to the ambient. Providing such a radiator 48 in prior art devices would lead to less efficient devices, as less heat energy would be transferred from the photovoltaic cells to the thermopiles.

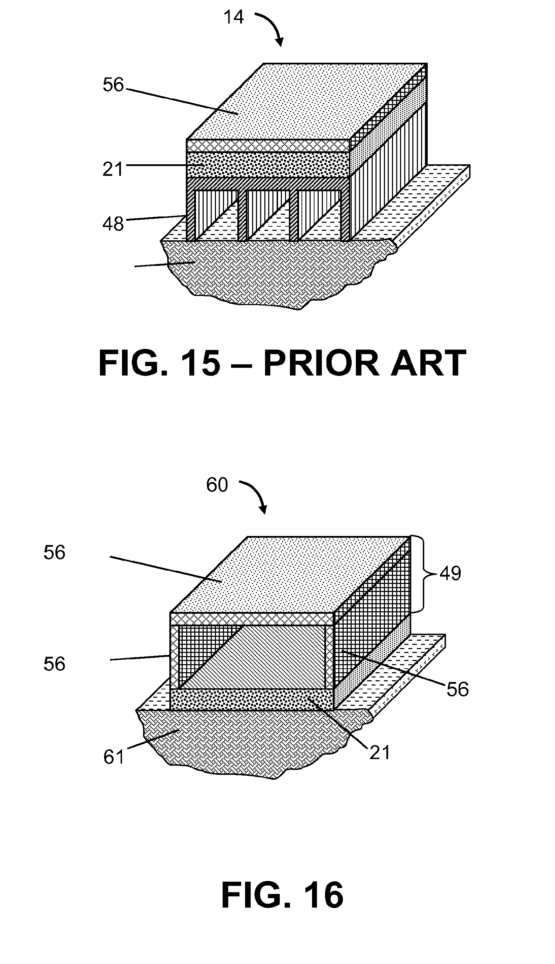

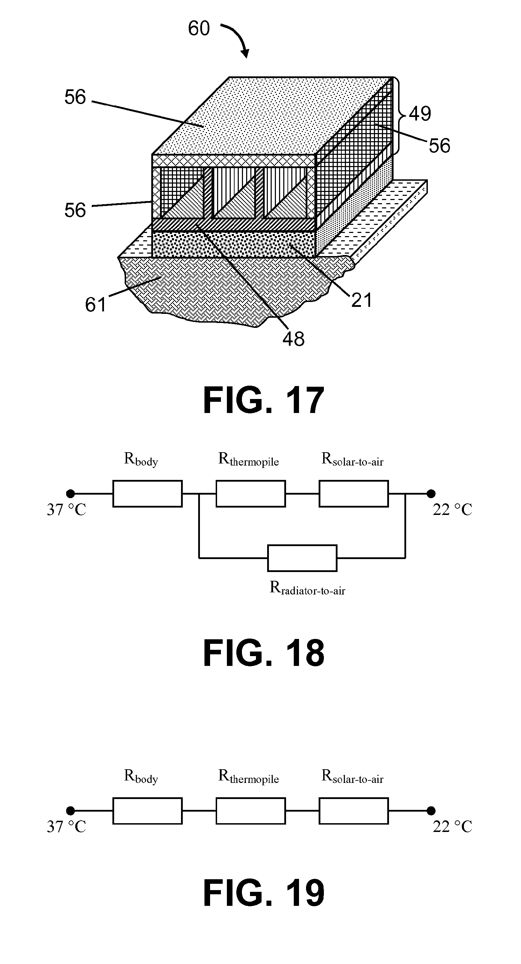

Calculations were performed related to the indoor power generation by wearable hybrid energy scavengers comprising a thermopile unit 50 composed of a single thermopile 21 and photovoltaic cells 56, wherein the scavengers are located on the skin of a human being. It was assumed that the hybrid energy scavenger occupies 1 cm² on the skin. The two basic designs according to the prior art that were analysed are shown in Fig. 14 and Fig. 15. Fig. 14 shows a prior art device wherein a thermopile 21 is attached to a photovoltaic cell 56. Fig. 15 shows a prior art device wherein a thermopile 21 is attached to a photovoltaic cell 56 and wherein the thermopile 21 is connected to a radiator 48 at a side opposite to the photovoltaic cell 56. Fig. 16 and Fig. 17 show two designs of a hybrid energy scavenger 60 according to embodiments of the present invention. In the device shown in Fig. 16, a thermopile 21 is attached to a heat dissipating structure 49 composed of photovoltaic cells 56. In the device shown in Fig. 17, the thermopile 21 is connected to a heat dissipating structure 49 comprising photovoltaic cells 56 and a cold plate shaped as a radiator 48 in between the thermopile 21 and the photovoltaic cells 56.

In the calculations it is assumed that in all devices the photovoltaic cells 56 are fabricated on a 0.5 mm-thick silicon substrate. The radiator 48 is assumed to be made of A1 with a thickness of 0.5 mm and comprising 4 fins with a fin height of 5 mm, wherein the height is the size in a direction perpendicular to the surface of the photovoltaic cell. This is a typical radiator design used in wearable devices. The thermal resistance of the thermopile 21 is assumed to be 50 cm²K/W. The hybrid energy scavenger is attached to the skin of a person with a body thermal resistance of 300 cm²K/W, an average value according to V. Leonov et al. in "Thermoelectric converters of human warmth for self-powered wireless sensor nodes", IEEE Sensors Journal, v.7, no.5 (2007), pp. 650-657. A core body temperature of 37°C and an ambient air temperature of 22 °C are used in the calculations. The heat transfer from the hybrid energy scavenger into the ambient air also depends on the thermal resistance of the body to which it is attached. A device attached to a wrist of a person is considered. The combined convection and radiation heat transfer from a unit surface of a wrist of 5 cm in diameter is described by a thermal resistance of the environment of 1010 cm²K/W at a skin temperature of 30 °C. This value was used for calculation of the heat transfer from the hybrid energy scavengers to the ambient air.

The thermal circuit used for modelling the prior art device of Fig. 15 is shown in Fig. 18. The area of the interface between the radiator 48 and ambient air amounts to 5.2 cm². The heat exchange between the scavenger and the ambient also occurs from the photovoltaic cell 56 which has an interface area of 1.2 cm² (including its side area) with the ambient. The heat flow from the body into the scavenger depends on the core temperature deep inside the body 61 and the temperature of ambient air, together with four thermal resistors as shown in Fig. 18. In Fig. 18, R_{body} is the thermal resistance of the human body, Thermopile is the thermal resistance of the thermopile 21, Rₛₒₗₐᵣ₋ₜₒ₋ₐᵢᵣ is the thermal resistance at the interface between the photovoltaic cell 56 and ambient air, and R_{radiator-to-air} is the thermal resistance at the interface between the radiator 48 and ambient air. In the calculations, the thermal resistance of the interface between the radiator 48 and the thermopile 21, the thermal resistance of the interface between the thermopile 21 and the photovoltaic cell 56, the thermal resistance of the radiator 48 and the thermal resistance of the photovoltaic cell 56 are neglected, as in practical applications they are preferably substantially smaller than the other thermal resistances in the system. For the device shown in Fig. 15, the heat flow from the body into the scavenger is calculated as being 9.04 mW. However, most of the heat coming from the heat source (the body) is dissipated from the radiator 48 at its interface with ambient air. From the calculations it follows that the heat flow through the thermopile 21 is only 1.62 mW. The resulting temperature difference over the thermopile is 0.081 °C. The produced power by a thermopile 21 is proportional to the square of the temperature difference on the thermopile ΔTₜₕₚ. Therefore, for comparison with other devices, (ΔTₜₕₚ)² is used as a figure of merit. For the device of Fig. 15, (ΔTₜₕₚ)² = 0.0065.

The second prior art device, shown in Fig. 14, can be modelled with the thermal circuit shown in Fig. 19. Calculations show that in this case the heat flow from the body into the device amounts to 12.57 mW, which is much less than in the example above. However, this heat flow passes through the thermopile 21, because contrary to the device of Fig. 15, there is no radiator between the body and the thermopile. The resulting temperature difference ΔTₜₕₚ over the thermopile 21 of the device according to Fig. 14 equals 0.629 °C, which is much larger than in the device according to Fig. 15. Therefore in this case (ΔTₜₕₚ)² = 0.395, and the thermopile 21 in this device produces 60.5 times more electrical power than the one with a radiator in between the body and the thermopile.

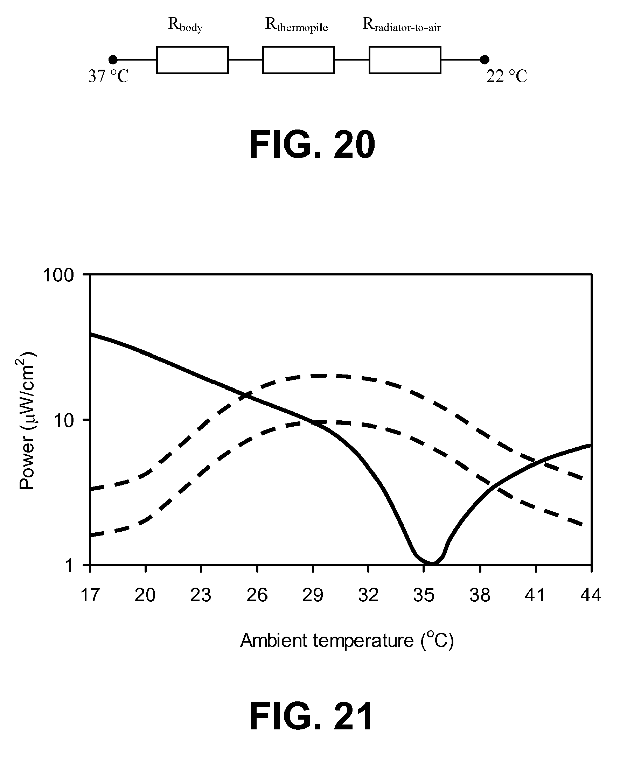

Next a hybrid energy scavenger according to embodiments of the present invention is modelled, the scavenger comprising a heat dissipating structure 49 composed of photovoltaic cells 56 as shown in Fig. 16. The total area of the interface between the photovoltaic cells 56 and air is 5.1 cm². The thermal circuit used for modelling this device is shown in Fig. 20, wherein R_{radiator-to-air} is the thermal resistance at the interface between the photovoltaic cells 56 and ambient air. Calculations show that the heat flow between the body and the device equals 27.35 mW. Therefore, ΔTₜₕₚ = 1.37 °C, i.e. much larger than in the two prior art devices discussed above. This leads to (ΔTₜₕₚ)² = 1.87, thus the thermopile in this device produces 287 times more electrical power than the prior art device shown in Fig. 15.

By adding a cold plate shaped as a radiator 48 in between the thermopile 21 and the photovoltaic cells 56 of the heat dissipating structure 49, a device according to embodiments of the present invention can be further improved. Such a device is illustrated in Fig. 17, while the corresponding thermal circuit is shown in Fig. 20. In the example shown, it is assumed that the radiator 48 comprises two additional fins (in addition to the two fins composed of photovoltaic cells 56 in the device of Fig. 16). This leads to a total area of 7 cm² (total area of the interface between photovoltaic cells 56 + metal fins on one hand and air on the other hand) for heat exchange between the heat dissipating structure 49 and ambient air. The heat flow through the thermopile 21 is in this case equal to 30.33 mW. The resulting ΔTₜₕₚ = 1.52 °C, therefore (ΔTₜₕₚ)² = 2.30, and the thermopile 21 in this device produces 354 times more electrical power than the prior art device shown in Fig. 15.

In the present document the description of a hybrid energy scavenger 60 according to embodiments of the present invention relates to a wearable energy scavenger wherein the heat source is a human body, for example a hybrid energy scavenger attached to a wrist or to a forehead of a person. However, this is only by means of an example and is not intended to be limiting for the invention, which is applicable for all ambient heat sources and heat sinks with high thermal resistance (e.g. between 10 cm² K/W and 1000 cm² K/W), like, e.g. endotherms and ambient air, i.e. in case of limited heat flow.

The power conditioning electronics of a hybrid energy scavenger 60 according to embodiments of the present invention may have a charge storage element, such as a supercapacitor or a rechargeable battery, e.g. a NiMH cell. This storage element may be charged from two electrical circuits, i.e. a thermopile circuit and a photovoltaic cells circuit. In conditions of an office with good illumination conditions, both units, the photovoltaic cells 56 and the thermopile unit 50, can be more or less equal in power supplying abilities. Depending on the particular positioning of the hybrid energy scavenger 60 on a human body, the illumination conditions may change; simultaneously, the available heat flow and therefore the power generated by the thermopile unit 50 may change. On a head of a person working in the office at an ambient temperature of e.g. 20-22 °C, a power of 2-6 µW/cm² can for example be generated by the photovoltaic cells, while up to 30 µW/cm² can be generated in the same conditions by the thermopile unit. This was experimentally verified. In such conditions, the thermopile unit 50 dominates the power production. However, at higher ambient temperatures, e.g. 29-30 °C, e.g. as a result of incident sun light, the power generated by the thermopile unit 50 may decrease to about 10 µW/cm² or less, while the photovoltaic cells 56 may generate more power than 10 µW/cm², i.e. more than the thermopile unit. At night and at home, i.e. at low light levels, the photovoltaic cells do not generate any significant power input. When a person is walking outdoor at 36 °C air temperature, the thermopile unit produces power only periodically (See: V. Leonov, T. Torfs, N. Kukhar, C. Van Hoof, and R. Vullers in "Small-size BiTe thermopiles and a thermoelectric generator for wearable sensor nodes", Proceedings of the 5th European Conf. on Thermoelectrics, Odessa, Ukraine, Sep 10-12, 2007, pp. 76-79.). Therefore, the photovoltaic cells in such conditions completely dominate, e.g. providing 1-2 mW/cm² and more. In winter, when it is cold, the thermopile unit works better, while the illumination conditions are usually worse due to a lack of sunlight. In summer, on the contrary, the thermopile unit can be outperformed by the photovoltaic cells. An example of the expected power input, on 24-hour average, from the thermopile unit 50 and from the photovoltaic cells 56 of the hybrid energy scavenger 60 according to embodiments of the present invention, is plotted in Fig. 21 (the solid line is for the thermopile unit and the dashed lines are for photovoltaic cells 56, depending on the average illumination conditions). The particular ratio of the curves can be different, e.g. depending on the particular application, e.g., for indoor devices or for devices to be worn both indoor and outdoor.

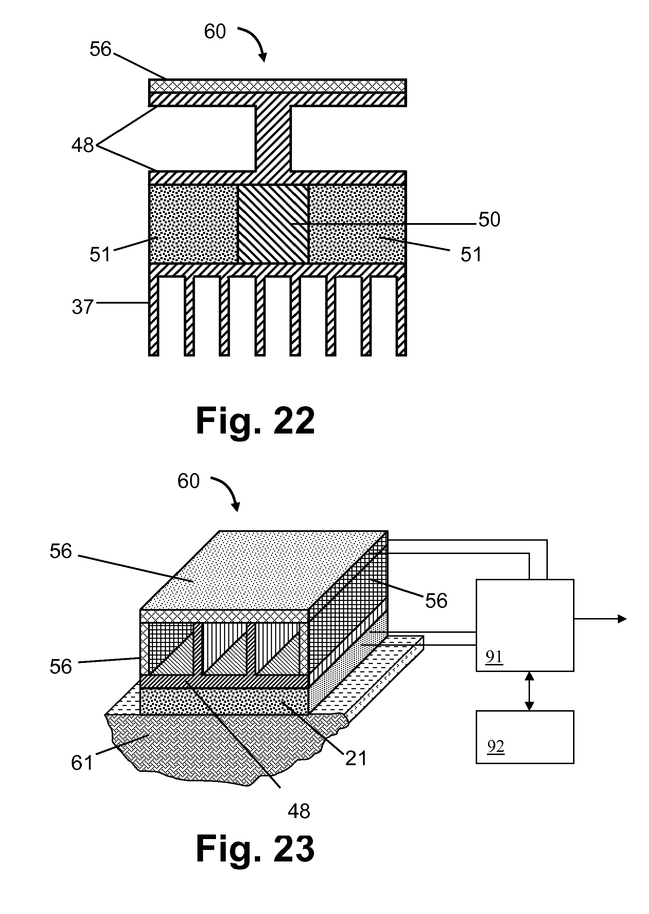

Using the hybrid energy scavenger 60 on a head of a person or on animals can be complicated by the presence of their hair/coat, thermally isolating the hot plate 37 from the skin. Therefore, a pin-featured or a fin-featured hot plate 37 as shown in Fig. 22 may be used to provide a thermal shunt to the hair/coat. The hot plate 37 is not a heat exchanger in this case, but is shaped as a comb for providing a thermal shunt between the scavenger 60 and the heat source, e.g. providing a low thermal resistance between the thermopile unit 51 and the heat source such as the skin. The hybrid energy scavenger 60 is then to be put on the head of a person or on the animal having a coat while "combing" their hair with the scavenger. The pins/fins of the hot plate 37 penetrate well through the hair/coat and reach the skin; after that, the hybrid energy scavenger 60 may be fixed on the body using a strap, a belt, a cap, etc.

Positioning the hybrid energy scavenger 60 on areas of the body of an endotherm proximal to the body inner organs referred to as a core of the body, e.g. the brain, may allow further increase of the generated power. In case of a human being, the optimal position of the hybrid energy scavenger 60 is on the temples of his head and on his forehead. In this case, the hybrid energy scavenger 60 becomes effective also during nocturnal time, i.e. on a sleeping person. By providing a pin-featured or fin-featured hot plate 37 (Fig. 22), according to the embodiments of the present invention, however, makes it possible to place the hybrid energy scavenger 60 on a part of the head covered with hairs, providing that the surrounding air is much less heated by the head because of the natural thermal isolation provided by hair. Therefore, the photovoltaic cells 56 and the radiator 48 are surrounded with air at a lower temperature than on an open skin surface such as a forehead, ensuring better power generation.

Fig. 23 shows a power supply which uses the hybrid energy scavenger of Fig.17, although any of the hybrid energy scavengers could be substituted for the one of Fig. 17. The power supply 91 receives a first electrical input from the photovoltaic cells 56 and a second electrical input from the thermopile unit 21. An energy storage cell 92, such as battery, is connected to an output of the power supply 91 for storage of generated energy. In use, energy is generated by one, or both, of the photovoltaic cell 56 and the thermopile unit 21. An electrical output is provided to a load, or the electrical energy which has been generated can be stored in cell 92. Stored energy can be released from cell 92 to provide an electrical output to the load.

As the hybrid energy scavenger 60 according to embodiments of the present invention may also be used for outdoor applications at temperatures above body core temperature and with large radiant heat from sun, the hybrid energy scavenger 60 may be used in reverse mode of operation, i.e. when the heat flow direction is from the ambient into a body, or to another surface, on which the device is mounted.

## Claims

1. A hybrid energy scavenger (60) for connection between a heat source and a heat sink, the hybrid energy scavenger (60) comprising:
a hot plate (37) for connection to the heat source;
a heat dissipating structure (49) for connection to the heat sink;
a thermopile unit (50) mounted between the hot plate (37) and the heat dissipating structure (49);
and **characterised in that** the heat dissipating structure (49) comprises at least one photovoltaic cell (56).

2. A hybrid energy scavenger (60) according to claim 1, wherein the at least one photovoltaic cell (56) has a thermal conductance of substantially greater than 0.5 W/cm.K.

3. A hybrid energy scavenger (60) according to any one of the previous claims, wherein the at least one photovoltaic cell (56) is mounted on an element of the heat dissipating structure (49).

4. A hybrid energy scavenger (60) according to claim 3, wherein the at least one photovoltaic cell (56) is thermally connected to the element of the heat dissipating structure (49) on which it is mounted.

5. A hybrid energy scavenger (60) according to any one of the preceding claims, wherein the at least one photovoltaic cell (56) is a structural element of the heat dissipating structure (49).

6. A hybrid energy scavenger (60) according to claim 5, wherein every structural element of the heat dissipating structure (49) consists of a photovoltaic cell (56).

7. A hybrid energy scavenger (60) according to any one of the previous claims, wherein the heat dissipating structure (49) comprises a cold plate (38), the cold plate (38) being positioned in between the thermopile unit (50) and the at least one photovoltaic cell (56).

8. A hybrid energy scavenger (60) according to any one of the previous claims, wherein the heat dissipating structure (49) comprises a radiator (48).

9. A hybrid energy scavenger (60) according to any one of the previous claims, further comprising a thermally conductive spacer positioned between the thermopile unit (50) and at least one of: the hot plate (37) and the heat dissipating structure (49).

10. A hybrid energy scavenger (60) according to any of the preceding claims, wherein said heat source is an animal, a human being, a clothed human being or ambient air and wherein said heat sink is ambient air, an animal, a human being or a clothed human being.

11. A hybrid energy scavenger (60) according to any of the preceding claims, wherein the heat source is a space object or an artificial space object and wherein the heat sink is interplanetary space, a space object or an artificial space object.

12. A hybrid energy scavenger (60) according to any of the preceding claims, wherein the heat source is a distant radiating object or a plurality of distant radiating objects like space objects or ambient objects on earth.

13. A hybrid energy scavenger (60) according to any one of the previous claims, which is in the form of a wearable device.

14. A wearable device or an autonomous device comprising a hybrid energy scavenger according to any one of the preceding claims.

15. A method of generating electrical energy using the hybrid energy scavenger according to any one of claims 1 to 13.

## Amended claims

### Amended claims in accordance with Rule 137(2) EPC.

**1.** A hybrid energy scavenger (60) for connection between a heat source and a heat sink, the hybrid energy scavenger (60) comprising:
a hot plate (37) for connection to the heat source;
a heat dissipating structure (49) for connection to the heat sink;
a thermopile unit (50) mounted between the hot plate (37) and the heat dissipating structure (49) for providing a first electrical output in response to a temperature difference across the thermopile unit (50);
and wherein the heat dissipating structure (49) comprises at least one photovoltaic cell (56) for providing a second electrical output in response to illumination of the at least one photovoltaic cell (56).

**2.** A hybrid energy scavenger (60) according to claim 1, wherein the at least one photovoltaic cell (56) has a thermal conductance of substantially greater than 0.5 W/cm.K.

**3.** A hybrid energy scavenger (60) according to any one of the previous claims, wherein the at least one photovoltaic cell (56) is mounted on an element of the heat dissipating structure (49).

**4.** A hybrid energy scavenger (60) according to claim 3, wherein the at least one photovoltaic cell (56) is thermally connected to the element of the heat dissipating structure (49) on which it is mounted.

**5.** A hybrid energy scavenger (60) according to any one of the preceding claims, wherein the at least one photovoltaic cell (56) is a structural element of the heat dissipating structure (49).

**6.** A hybrid energy scavenger (60) according to claim 5, wherein every structural element of the heat dissipating structure (49) consists of a photovoltaic cell (56).

**7.** A hybrid energy scavenger (60) according to any one of the previous claims, wherein the heat dissipating structure (49) comprises a cold plate (38), the cold plate (38) being positioned in between the thermopile unit (50) and the at least one photovoltaic cell (56).

**8.** A hybrid energy scavenger (60) according to any one of the previous claims, wherein the heat dissipating structure (49) comprises a radiator (48).

**9.** A hybrid energy scavenger (60) according to any one of the previous claims, further comprising a thermally conductive spacer positioned between the thermopile unit (50) and at least one of: the hot plate (37) and the heat dissipating structure (49).

**10.** A hybrid energy scavenger (60) according to any of the preceding claims, wherein said heat source is an animal, a human being, a clothed human being or ambient air and wherein said heat sink is ambient air, an animal, a human being or a clothed human being.

**11.** A hybrid energy scavenger (60) according to any of the preceding claims, wherein the heat source is a space object or an artificial space object and wherein the heat sink is interplanetary space, a space object or an artificial space object.

**12.** A hybrid energy scavenger (60) according to any of the preceding claims, wherein the heat source is a distant radiating object or a plurality of distant radiating objects like space objects or ambient objects on earth.

**13.** A hybrid energy scavenger (60) according to any one of the previous claims, which is in the form of a wearable device.

**14.** A wearable device or an autonomous device comprising a hybrid energy scavenger according to any one of the preceding claims.

**15.** A method of generating electrical energy using the hybrid energy scavenger according to any one of claims 1 to 13.
